# EUROPEAN PATENT APPLICATION

(11) **EP 0 788 300 A1**
(43) Date of publication of application: **06.08.1997**
(21) Application number: 97101013.7
(22) Date of filing: 23.01.1997
(51) Int. Cl.: H05K 3/34, C23C 24/00

(54) **Method and apparatus for forming a conductive layer on a printed wiring board terminal**

(30) Priority: 01.02.1996 US 595148
(71) Applicant: MOTOROLA, INC., Schaumburg, IL 60196 (US)
(72) Inventor: Letterman, James P., Jr., Mesa, Arizona 85208 (US); Asher, Reginald K., Sr., Scottsdale, Arizona 85250 (US); Asher, Reginald K., II, Phoenix, Arizona 85048 (US)
(74) Representative: Spaulding, Sarah Jane

(57) **Abstract**

A solder powder layer formed on an electrical terminal (25) for making an electrical connection is described. A first electrical potential (26) is applied to the electrical terminal (25) which is to receive the coating and a conductive powder is charged to a second electrical potential and formed into a cloud (22) for electrostatically attracting it to the electrical terminal (25). After the conductive powder coating is applied to electrical terminal (25) it is heated in a reflow chamber for melting and adhering to electrical terminal (25).

## Description

### Background of the Invention

This invention relates, in general, to electrical connections, and more particularly, to the use of powder coating in forming an electrical connection on an integrated circuit printed wiring substrate.

Leads or terminals of electrical components are generally coated with a conductive substance such as solder for connecting them to a system printed circuit board. If the electrical component is an integrated circuit mounted on a lead frame the conventional method for coating the leads is to dip them in a molten solder bath prior to mounting the semiconductor die. This method is adequate when the number of leads is relatively small and the spacing between them large but when applied to a complex integrated circuit having as many as several hundred leads situated in a closely spaced array the solder dipping method results in undesirable bridging of the leads.

A known method for coating the terminals of such complex integrated circuits uses small solder balls for forming the conductive coating. A flux material is first applied to the terminals or leads to be coated. Small balls of solder are then loaded into a fixture containing vacuum lines for holding them in an array which matches the pattern of the terminals. The vacuum is released, dropping the solder balls onto the terminals where they are held in place by the surface tension of the flux material. The package is then transferred to a reflow furnace for heating the solder for adhering to the terminals.

The adequacy of the solder ball method depends on the degree of control which is maintained over the size of the solder balls. Too small a ball will not contain enough solder to completely coat the lead, resulting in weak or an open connection to the system printed wiring board; too large a ball will supply excess solder to the lead and form bridges.

A recurring problem with the solder ball method is the difficulty of keeping the tiny vacuum passages from becoming clogged which would prevent the vacuum from taking up a solder ball by the fixture. As the number and density of integrated circuit leads increases, the above described method requires ever smaller solder balls in order to avoid bridging problems. These smaller solder balls then require smaller vacuum lines for handling them. However, the smaller vacuum lines are more easily clogged and more difficult to clear when they do become clogged. Moreover, solder balls of uniform quality in the very small sizes required are not presently available commercially.

The above method also provides little flexibility in the choice of materials used to form the solder coating because only a limited variety of solder compositions are commercially available. The most widely available composition, a tin-lead alloy, is the cheapest, but it is a highly toxic and environmentally hazardous material. The few other available compositions are all more expensive than tin-lead alloy, thereby inhibiting efforts to eliminate the use of hazardous materials without sacrificing manufacturing efficiency.

Accordingly, it would be advantageous to have a method for forming a conductive layer on tightly spaced semiconductor package leads or terminals that offers protection from solder bridging. It would be of further advantage if the method provides the flexibility to change the composition of the conductive layer to increase quality or to eliminate the use of environmentally hazardous chemicals without increasing manufacturing costs.

### Brief Description of the Drawings

FIG. 1 is a cross-sectional side view of a vacuum apparatus that aligns and applies solder balls to a printed wiring board in accordance with the prior art; and
FIG. 2 is an isometric view of a printed wiring board terminal being coated with a conductive material in accordance with the present invention.

### Detailed Description of the Drawings

Many complex semiconductors are mounted, wire bonded and encapsulated directly on substrates which are printed wiring boards. Printed traces connect the wire bonds to the package terminals which are typically coated with solder for electrically connecting them to a system. Because of its low cost and wide availability, the solder coating is generally formed from an alloy composed of 63% tin and 37% lead.

The package terminals are prepared for soldering by applying a flux material to enhance solder flow, to clean and remove oxides and to promote fusion or alloying of the solder with the terminal. Enough flux must be used to cover the terminals but not so much that it flows between them. Once the flux has been applied solder is deposited for coating the terminals.

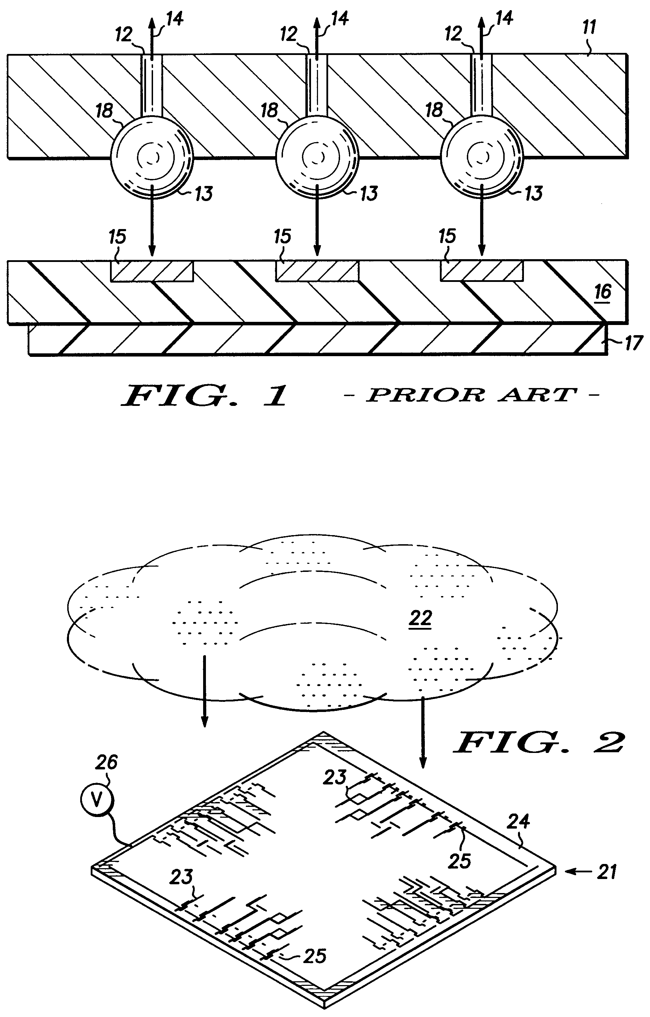

FIG. 1 is a cross-sectional side view of a vacuum apparatus for depositing solder onto semiconductor package terminals 15 in accordance with the prior art. In one method flux (not shown) is applied to the terminals 15 through a mask placed on a substrate 16 that exposes the terminals 15 and blocks off the spaces between them. A template 11 contains a system of vacuum openings 12 each connected to a recess 18 for taking up solder balls 13. The vacuum openings 12 are arrayed in a pattern corresponding to that of the package terminals 15. When template 11 is positioned over a container of solder balls 13 the vacuum 14 is applied to openings 12 and a solder ball 13 is taken up into each recess 18. In one variation of the known method, the above described application of flux to the terminals is omitted and the flux is instead applied to the solder balls 13 by positioning template 11 over a container of liquid flux and then dipping the solder balls 13 just deeply enough into the flux to partially coat each solder ball 13.

Regardless of which method is used for applying the flux, template 11 is placed above substrate 16 such that solder balls 13 are closely aligned with terminals 15. When vacuum 14 is shut off, solder balls 13 are released to drop out of recesses 18 and fall onto terminals 15 where surface tension keeps them in place until they are transferred to a chamber where they are melted for flowing onto terminals 15.

Each step of the conventional vacuum method is a source of potential solder coating defects. Openings 12 are small, typically 12 mils in diameter, and easily clogged with flux or other materials. Their small size makes them difficult to clean thoroughly. If a particular opening 12 is clogged no solder ball 13 will be taken up and the corresponding terminal 15 will not be coated.

Tight control must be maintained over the size of solder balls 13. If they are too large excess solder will flow into the spaces between terminals 15 and cause bridging. If they are too small the terminals 15 will not be completely coated and will form unreliable connections to the system. Moreover, solder balls 13 must be nearly spherical because if they are elongated they will be more likely to bridge and more likely to get stuck in openings 12 or recesses 18. The smallest commercially available solder balls 13 of sufficiently uniform quality for coating integrated circuit terminals 15 are about 20 mils in diameter. Solder balls 13 range in size from 20 mils in diameter to 30 mils in diameter. These available sizes are too large for coating newer integrated circuit packages with large arrays of densely packed leads. Such packages require solder balls 13 approximately 10 mils in diameter which solder ball manufacturers are unable to fabricate within the small percent deviation in size required to insure manufacturability.

FIG. 2 is an isometric view of a portion of a substrate 21 for mounting a semiconductor die illustrating the formation of a conducting layer on an electrical terminal 25 using conductive powder in accordance with the present invention. Terminals 25 are electrically connected to printed wires 23 which are in turn electrically connected to shorting strip 24. Shorting strip 24 normally circumscribes the perimeter of package 21 and is used for electrically connecting terminals 25 to each other during various manufacturing operations including the deposition of solder powder onto terminals 25. It is trimmed away from package 21 at the end of the fabrication process. It should be noted that a limited number of terminals 25 are shown for simplifying illustration of FIG. 2 and that hundreds or thousands of tightly spaced terminals are placed on the substrate 21.

Flux material is applied to terminals 25 through a mask. The substrate is then placed in a deposition chamber to place solder on terminals 25. Because electrostatic attraction is relied on to attract the conductive powder to terminals 25 the necessary electrical potentials are provided. Shorting strip 24 is electrically connected to a first voltage potential 26, which is generally ground, thereby effectively grounding the terminals 25 which are to be solder coated.

A cloud 22 of conductive material in powdered or dust form is then generated in the chamber to suspend the particles in a gaseous atmosphere by using a powder spray gun or by forcing a compressed gas through a bed containing the conductive powder. Cloud 22 is comprised of particles of a solder alloy or other equivalent combination of materials. As cloud 22 is formed, it is electrostatically charged to a second voltage potential which is typically between 30 kilovolts to 100 kilovolts for attracting to terminals 25. The particles of cloud 22 are attracted to terminals 25 and forms a uniform layer of solder material on each terminal as the material falls from the suspended state. Once the conductive powder has been deposited it is heated in a furnace for reflowing and adhering to terminals 25.

The particles comprising cloud 22 need not be of constant size to provide good coverage of terminals 25 as long as they are small in relation to the spacing and size of the terminals 25. Successful coating of terminals 25 spaced 39 mils apart has been observed with a cloud 22 comprised of particles whose average size is 31.5 microns in diameter and ranging from 25 microns to 38 microns in diameter.

With conventional methods the amount of conductive material deposited is determined exclusively by the size of the solder balls. There is little opportunity to optimize coverage for each application because solder balls are available only in a limited assortment of sizes. With the present invention coverage can be fine tuned for each application either by adjusting the electrostatic attractive charge applied to the conductive powder or by varying the time the package is in the deposition chamber.

The present invention also provides the flexibility to optimize the composition of the conductive coating because the particles comprising cloud 22 need not be of uniform composition. A mixture of individual powders comprised of different materials individually selected for their desired electrical, chemical or physical properties can be used to form cloud 22. This flexibility creates a better opportunity to eliminate the use and disposal of a hazardous material such as lead and replace it with another metal such as bismuth, silver, indium, or antimony without sacrificing quality or increasing manufacturing costs.

Powder coating using nonconductive powders for electrical insulation and for protection against weathering and corrosion has found acceptance in a wide variety of applications as a low cost alternative to liquid coating systems. For example, epoxy powder coating is used where void-free, low bulk electrical insulation is required, such as in automobile alternators and electric motors. The durability and weathering properties of urethane polyester or acrylic powder coating are used to protect such diverse products as automobile trim parts and as a porcelain replacement on appliances such as ranges and refrigerators.

Powder coating is performed at atmospheric pressure and has an environmental advantage over liquid coating methods in that the powders used are dry. Powder that is oversprayed or otherwise unused may be easily reclaimed. Where the powders are comprised of hazardous materials the ease of reclamation can eliminate the need to incorporate procedures for disposal. Because the powders are dry, no volatile organic compounds are present that need to be scrubbed from the atmosphere.

One embodiment of the present invention uses solder powder coating to form a conducting layer where fine geometries are present such as the terminals of a semiconductor device. A conductive powder comprised of particles from 25 microns to 38 microns in size is applied to the terminals using electrostatic attraction. The solder powder eliminates the need for solder balls and an unreliable vacuum apparatus to handle them. This method can be used for coating any electrical connection point but is most advantageous in applications such as semiconductor packaging wherein multiple individual connections must be made in a closely spaced area. The solder powder coating process is flexible, reliable and inexpensive and can eliminate the use of environmentally hazardous chemicals.

While specific embodiments of the present invention have been shown and described, further modifications and improvements will occur to those skilled in the art. It is understood that the invention is not limited to the particular forms shown and it is intended for the appended claims to cover all modifications which do not depart from the spirit and scope of this invention.

## Claims

1. A method for forming a conducting layer on an electrical terminal (25) of a substrate (21) comprising the steps of:
charging a conductive powder to a first voltage potential (26);
placing a second voltage potential on said electrical terminal (25) for attracting said charged conductive powder;
suspending said conductive powder in a gaseous atmosphere adjacent to said electrical terminal (25); and
electrostatically attracting said conductive powder to said electrical terminal (25).

2. The method as recited in claim 1 wherein said conductive powder consists of particles of a metal.

3. The method as recited in claim 2 wherein said metal is tin.

4. The method as recited in claim 3 wherein said conductive powder is a mixture of tin and a metal selected from a group consisting of lead, bismuth, silver, indium, and antimony.

5. The method as recited in claim 1, wherein said conductive powder is comprised of particles not exceeding 38 microns in diameter.

6. The method as recited in claim 1 further including the steps of:
placing a mask on said substrate (21) such that said electrical terminal (25) is exposed; and
applying flux through said mask to said electrical terminal (25).

7. A method for solder coating electrical terminals (25) of a printed wiring board (21), comprising a step of powder coating the electrical terminals (25) with a conductive solder powder.

8. The method as recited in claim 7 wherein said step of powder coating includes the steps of:
charging said conductive solder powder to a first voltage potential (26); and
coupling the electrical terminals (25) of the printed wiring board (21) to a second voltage potential wherein said conductive solder powder is electrostatically attracted to the electrical terminals (25).

9. The method as recited in claim 8 further including the steps of:
masking the printed wiring board such that the electrical terminals are exposed; and
applying flux to the electrical terminals.

10. The method as recited in claim 9 further including a step of heating the electrical terminals of the printed wiring board to reflow the conductive solder powder.
